# EUROPEAN PATENT SPECIFICATION

(11) **EP 2 474 212 B1**
(45) Date of publication and mention of the grant of the patent: **18.02.2015**
(21) Application number: 10751646.0
(22) Date of filing: 02.09.2010
(51) Int. Cl.: H05K 3/12, H01L 31/0224, H01L 21/677, H01L 31/18, H01L 21/68, H05K 1/02, H05K 3/00

(54) **METHOD AND APPARATUS TO DETECT THE ALIGNMENT OF A SUBSTRATE**
VERFAHREN UND VORRICHTUNG ZUR ERKENNUNG DER AUSRICHTUNG EINES SUBSTRATS
PROCÉDÉ ET APPAREIL POUR DÉTECTER L'ALIGNEMENT D'UN SUBSTRAT

(30) Priority: 03.09.2009 IT UD20090148
(43) Date of publication of application: 11.07.2012
(73) Proprietor: Applied Materials, Inc., Santa Clara, CA 95054 (US)
(72) Inventor: DE SANTI, Luigi, I-31027 Spresiano (IT); BACCINI, Andrea, 31030 Mignagola di Carbonera (IT); CELLERE, Giorgio, I-36040 Torri Di Quartesolo (IT); GALIAZZO, Marco, I-35127 Padova (IT); PASQUALIN, Gianfranco, I-31027 Spresiano (IT); VERCESI, Tommaso, I-31057 Silea (IT)
(74) Representative: Zimmermann & Partner
(86) International application number: PCT/EP2010/062835
(87) International publication number: WO 2011/026878

(56) References cited:
- EP-A1- 0 394 568
- JP-A- 2000 211 106
- US-A1- 2006 039 735
- US-A1- 2007 209 697

## Description

### FIELD OF THE INVENTION

Embodiments of the present invention generally relate to a method and an apparatus used to detect the alignment or position of a substrate during a sequence of printing steps. Embodiments of the present invention may be used to form conductive tracks on a substrate that is used to form a solar cell device.

### BACKGROUND OF THE INVENTION

Printing processes are generally known in the art, in particular serigraph prints, in which one or more printing steps are used to deposit a printed material on a substrate, so as to define corresponding printed tracks.

It is also known that this technique is widely used for forming photovoltaic cells on a substrate, for example, a wafer or thin sheet of silicon. Typically, during parts of the photovoltaic formation process various printed tracks, for example conductive tracks, are deposited in different printing stations disposed in sequence one after the other.

The production of the photovoltaic cells, and consequently the relative printing processes, are subject to very precise tolerances, and it is therefore necessary to control the movement and position of the substrate between one printing station and the next.

One known technique for carrying out this type of control of the position of a pattern to be deposited on the substrate is to deposit, during the printing process and with the same print material, at least one marker element that is used for alignment. The position of each marker is then verified in the following station, to detect the actual alignment and positioning of the pattern on the substrate.

Although, this known technique has some disadvantages with regard to the need to deposit of the marker element, which includes an increase in the amount of print material used, an increase in the production times, and also the printed conductive tracks can affect the deposited pattern's electrical properties, such as creating an unwanted electrical short. Furthermore, the positioning of the marker element with respect to the conductive tracks may not be consistent from one printing head to another, due to possible lack of uniformity of the printing patterns formed in different printing heads, or slight intrinsic errors of each printing station. These types of errors can cause misalignment of the print tracks even if the markers are perfectly aligned with each other.

Moreover, the deposited markers reduce the usable surface area of the photovoltaic cell, which can affect the solar cell's ability to transform solar energy into electric energy.

These disadvantages of the state of the art can be found not only in silk-screen printing techniques but also in other types of printing, for example laser printing, ink jet or others.

EP 0 394 568 A1 relates to aligning an object to be acted upon. An aligning system includes an object to be acted upon at predetermined locations, such as a circuit board to receive solder paste. There is a device, such as a stencil, characterised by the pattern for acting upon the object. A video probe is arranged to look at both the device and the object for providing image signals representative of both. A comparator compares the image signals to provide an error signal representative of misalignment between the device and the object. A positioner responsive to the error signal relatively positions the device and object to reduce the error. An operator causes the device to operate upon the object at the predetermined locations.

US 2006/0039735 A1 relates to an apparatus to align a substrate and a print head having a plurality of orifices so as to perform a printing operation by ejecting ink on the substrate. The apparatus comprises a camera unit provided between the substrate and the print head to photograph the plurality of orifices of the print head and the substrate so as to align the print head and the substrate, and a camera moving part to movably support the camera unit and to move the camera unit between the substrate and the print head.

US 2007/0209697 A1 relates to forming a first and a second printing pattern on a substrate used to form solar cell devices.

Therefore, there is need for a method and an apparatus that can detect the alignment of the substrate in different operating stations in a simple, precise, reliable way that overcomes the disadvantages of the state of the art.

The Applicant has devised, tested and embodied the present invention to overcome the shortcomings of the state of the art and to obtain these and other purposes and advantages.

### SUMMARY OF THE INVENTION

The present invention is set forth and characterized in the independent claims, while the dependent claims describe other characteristics of the invention or variants to the main inventive idea.

In accordance with the above purpose, a method according to the present invention is applied to detect the alignment of a pattern on the substrate in a sequence of printing steps, in which a printed track is deposited on a surface of the substrate. In embodiments of the invention, a portion of the first printed track is used as a reference point, such as for example a crossing point of the printed tracks, to aid in the alignment and positioning of a second printed track that is to be deposited on the substrate in a subsequent printing step.

In particular, the method according to the invention for detecting the alignment of a substrate during a sequence of printing steps, comprises:
detecting in a detection unit a position of at least one printing track, selected between a finger and a busbar, and forming a pattern printed onto a surface of the substrate in a first printing station,
determining a reference point in at least a portion of said printing track,
comparing in a detection unit the actual position of said reference point with an expected, or previously detected, position of said reference point;
determining an offset between the actual position and the expected, or previously detected, position of said reference point;
adjusting the reciprocal position between the printing head of a second printing station and the substrate for to account for the determined offset; and
printing a second pattern onto the first pattern.

In particular, the method according to one embodiment of the present invention provides completing an identification step in which a detection unit is used to determine the position of the at least one reference point formed by at least a portion of the printed tracks disposed on a surface of a substrate, and printed in a first printing station, and then performing a comparison step in which the position is compared with an expected, or previously detected, position of the reference points on a print support.

In one embodiment of the present invention, the results of the comparison step are used to align the subsequent printing head according to the possible existing offset between the position detected and the position expected of the reference points formed by the printing tracks.

In another embodiment, the support is aligned with respect to the printing head, that remains fixed.

In one embodiment, the print track or tracks are used as a virtual reference point to determine the position of the substrate in the subsequent printing steps. Use of portions of the printed track as a virtual reference point thus allows for the reduction in the production times and the material, while also reducing the risk of compromising the integrity of the printed tracks. Furthermore, by using the virtual reference points found on the printed track(s), instead of applying an external marker element, one can be assured that any correction to the alignment made in a subsequent print station is directly related to the printed track(s) themselves, thus avoiding an error in the positioning of the marker element relative to the printed tracks.

In one embodiment, in which the substrate is for example, a silicon wafer that has printed tracks made of a conductor paste disposed thereon. The conductor paste is deposited in pattern that comprises an array of tracks of the conductor paste that are aligned substantially parallel to each other, known as "fingers", and are connected at the ends by at least two transverse tracks known as "busbars." In one embodiment, one or more reference points are formed at the intersection between the fingers and the busbars. In one embodiment, three reference points are formed and used by the control system to guarantee the correct positioning and alignment of the wafer in a subsequent printing station, based on the position of the fingers and the busbars printed in the previous station.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1 is a schematic view of an apparatus according to the present invention;
Figure 2 is a schematic view of a possible printing conformation of a substrate;
Figure 3 shows schematically a step of comparison in the method according to the present invention.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION OF A PREFERENTIAL FORM OF EMBODIMENT

Embodiments of the present invention may generally provide an apparatus 10 that is usable for aligning a printing device to a printed pattern formed on a substrate, such as a wafer 11, in an apparatus 100 for the production of photovoltaic cells. In this case, the apparatus 10 is used to detect the alignment of the wafer 11 which is positioned between two printing stations, respectively first station 12 and second station 13. In one embodiment, the apparatus 100 comprises a series of printing units that are found in each of the printing stations and are used in an apparatus 100 for the production of photovoltaic cells.

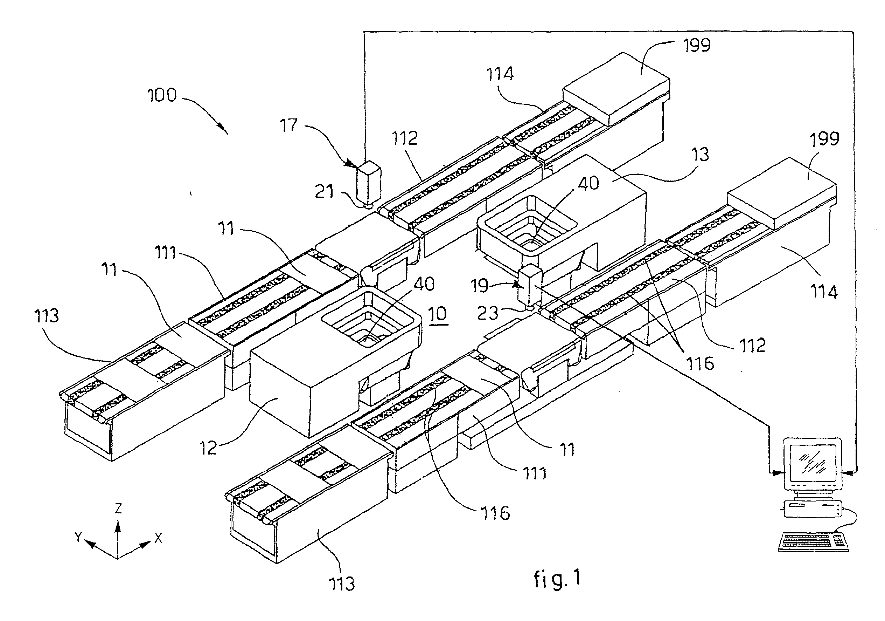

Figure 1 is a schematic isometric view of one embodiment of the apparatus 100 in which the alignment apparatus 10 of the present invention may be used. In the embodiment, the apparatus 100 generally includes two conveyors 111, two printing stations 12, 13, two outgoing conveyors 112, and a command and control unit 20. The incoming conveyors 111 are configured in a parallel processing configuration so that each can receive an unprocessed wafer 11 from an input device, such as an input conveyor 113, and transfer each unprocessed wafer 11 to a couple of printing station 12, 13. Additionally, the outgoing conveyors 112 are configured in parallel so that each can receive a processed wafer 11 from a printing station 12, 13 and transfer each processed wafer 11 to a wafer removal device, such as an exit conveyor 114. In one embodiment, the input conveyor 113 and the exit conveyor 114 are automated substrate handling devices that are part of a larger production line, for example the Softline^{™} tool that is connected to the apparatus 100. In one embodiment, each exit conveyor 114 is adapted to transport processed wafers 11 through an oven 199 to cure material deposited on the wafer 11 via the printing stations 12, 13.

In one embodiment, the incoming conveyor 111 and outgoing conveyor 112 include at least one belt 116 to support and transport the wafers 11 to a desired position within the apparatus 100 by use of an actuator (not shown) that is in communication with the control unit 20. While Figure 1 generally illustrates a two belt style substrate transferring system, other types of transferring mechanisms may be used to perform the same substrate transferring and positioning functions without varying from the basic scope of the invention.

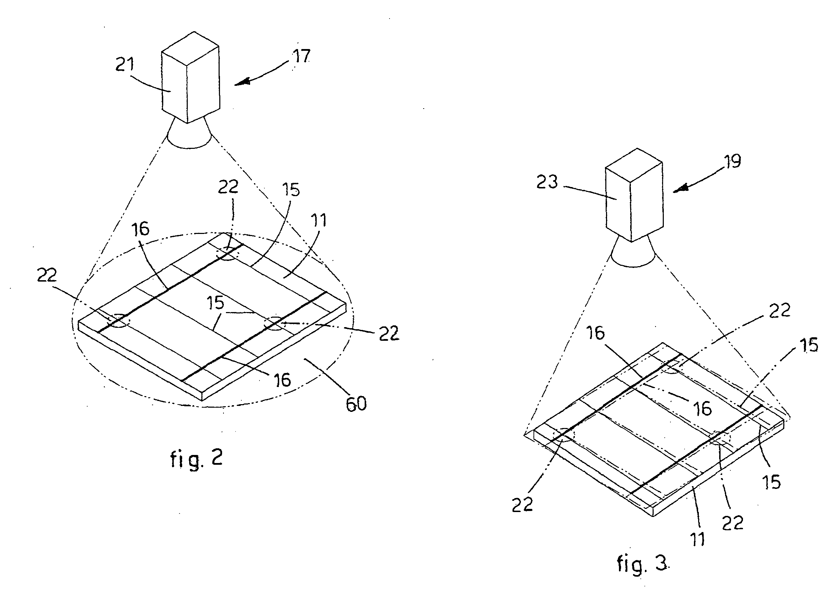

In particular, the upper surface of each wafer 11 is adapted to receive a plurality of print tracks, for example conductive tracks, that are used to collect a portion of the current generated by the formed solar cell device. In one example, shown in Figures 2 and 3, the printed tracks include a plurality of first tracks 15, called fingers, substantially parallel to each other, and second tracks 16, called busbars, which are substantially perpendicular to and intersect the first tracks 15 to form an electrical connection there between. While the printed pattern provided on each wafer 11 shown in Figures 2 and 3 has two printed tracks, this configuration in not intended to be limiting as to the scope of the invention described herein, since a single printed track or three or more different tracks can also be used depending on the operating requirements of the photovoltaic cell.

The printing stations 12 and 13 are configured to deposit different print layers or patterns on a surface of the wafer 11. In one example, the two printing heads 12 and 13 are specifically configured to deposit the first and second tracks 15 and 16, in different complementary patterns. In another example, the two printing heads 12 and 13 can be used to form multiple overlapping layers having the same printing pattern, and/or layers of materials having different physical or chemical properties.

However, in any case, the printed pattern obtained in the first printing station 12 must be accurately aligned, or in other way positioned in a strict correlation with the printed pattern obtained in the second printing station 13.

In one embodiment, the printing stations 12 and 13 include a plurality of actuators, for example stepper motors or servomotors, that are in communication with the command and control unit 20 and are used to adjust the position and/or angular orientation of a printing head 40 disposed within the relative station 12, 13 with respect to the wafer 11 being printed. In one embodiment, the printing head 40 is a metal sheet or plate with a plurality of features, such as holes, slots, or other apertures formed therethrough to define a pattern and placement of screen printed material (*i.e.,* ink or paste) on a surface of the wafer 11. In general, the screen printed pattern that is to be deposited on the surface of the wafer 11 is aligned to the wafer 11 in an automated fashion by orienting the printing head in a desired position over the wafer surface using the actuators and information received by the unit 20, as disclosed hereinafter. In one embodiment, the printing stations 12 and 13 are adapted to deposit a metal containing or dielectric containing material on a wafer 11 having a width between about 125 mm and 156 mm and a length between about 70 mm and 156 mm. In one embodiment, the printing stations 12 and 13 are adapted to deposit a metal containing paste on the surface of the wafer 11 to form the metal contact structure on a surface of the wafer 11.

The apparatus 10 according to the present invention comprises an identification or detecting station 17 disposed immediately downstream of the first printing station 12, with respect to the direction of movement of the wafer 11, a comparison station 19 disposed immediately upstream of the second printing station 13 and a command and control unit 20 electronically connected at least to the identification station 17 and to the comparison station 19.

The control unit 20 may include a central processing unit (CPU) (not shown), memory (not shown), and support circuits (or I/O) (not shown). The CPU may be one of any form of computer processors that are used in industrial settings for controlling various chamber processes and hardware (*e.g*., conveyors, optical inspection assemblies, motors, fluid delivery hardware, etc.) and monitor the system and chamber processes (*e.g*., substrate position, process time, detector signal, etc.). The memory is connected to the CPU, and may be one or more of a readily available memory, such as random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the control unit 20 determines which tasks are performable on a substrate. Preferably, the program is software readable by the control unit 20, which includes code to generate and store at least substrate positional information, the sequence of movement of the various controlled components, substrate optical inspection system information, and any combination thereof.

It should be noted that, while not shown in the drawings, one or more processing chambers can be disposed between the two printing stations 12 and 13 to perform various different operating steps that are complementary to the printing process, such as drying, doping the printed material, high-temperature annealing, alignment on the pattern obtained, printing metal or other similar function.

The identification station 17 comprises a video camera 21, for example a CCD camera, disposed above and substantially perpendicular to a surface of the wafer 11 that is parallel to a transfer plane 60 on which the wafer 11 passes after exiting the first printing station 12.

The video camera 21 is suitable to detect an image of the upper surface of the wafer 11 that has the first and second tracks 15 and 16 disposed thereon by a printing process performed in the first printing station 12. The detected image is processed by the control unit 20 so as to detect at least three crossing points between the first tracks 15 and the second tracks 16, and so as to establish three reference points 22 provided directly by the tracks 15, 16 themselves, without using the prior art marker elements or fiducials. In one example, as shown in Figures 2 and 3, the reference points 22 are schematically represented as circular regions bounded by a discontinuous line. In one embodiment, three reference points 22 are detected, to identify the positioning of the formed pattern on the wafer 11. In some configurations, it may be desirable to detect fewer or more than three reference points 22.

The data contained in an image, which contains the virtual reference points 22, is sent from the video camera 21 by means of the command and control unit 20 to the comparison station 19.

The comparison station 19 comprises a video camera 23, for example a CCD camera, also disposed above and perpendicular to the transfer plane on which the wafer 11 passes, such as at the entrance to the second printing station 13.

In one embodiment, the video camera 23 is generally suitable to project virtually the image of the wafer 11 detected by the video camera 21 with the current position of the substrate under the video camera 23 by use of the reference points 22.

In this way, a movement of the wafer 11, or of its support, between the identification station 17 and the comparison station 19 can be detected in order to take account of it during the subsequent step of alignment.

In one embodiment, moreover, the position of the reference points 22 identified on the printed tracks 15 and 16 is compared with a known position, and sent to the control unit 20 in order to adjust the subsequent printing head in the printing station 13.

In Figure 3, a virtually projected image is shown by a series of dashed lines, simply to schematically illustrate the functioning thereof and not represent the real operating conditions.

Therefore, by comparing the virtual image detected by the video camera 21 and by the video camera 23 the deviation between the reference points 22 are detected, to determine the difference in the position of the wafer 11 currently under the video camera 23 with the data collected by the video camera 21 positioned at the exit from the first printing station 12. In one embodiment, the deviation is directly detected and determined using the reference points 22 formed at the intersection of the first and second tracks 15 and 16, without needing other reference points.

In one embodiment, a software provided in the control unit 20 makes the comparison between the data detected in the two stations 17 and 19.

The value of the deviation detected is sent to the command and control unit 20, which processes the datum according to programmed or programmable tolerance parameters, and possibly commands a station for the correction of the position of the wafer 11, of a substantially known type and not shown in the drawings, to position and align the wafer 11 correctly before the second printing station 13.

It is clear, however, that modifications and/or additions of parts or steps may be made to the method and apparatus 10 as described heretofore, without departing from the field and scope of the present invention.

For example, it comes within the field of the present invention to provide a method and an apparatus in which the wafer 11 remains always stationary in its initial position and the printing stations 12 and 13 are each positioned sequentially over the wafer 11 to deposit the relative print tracks 15 and 16.

In this embodiment, the detection of the reference points 22 and the subsequent comparison with the expected position of the wafer 11 is used to correct the position of the second printing station 13 with respect to the wafer 11, so as to guarantee the correct alignment of the print tracks 15 and 16 printed by the relative printing stations 12 and 13.

In this embodiment it is advantageous, but not necessary, to provide a single detection unit which functionally comprises the characteristics both of the identification station 17 and also of the comparison station 19, so that it can carry out both the operations to detect the reference points 22 and also to compare the position of these reference points 22 to the expected positions thereof

## Claims

1. A method of detecting the alignment of a substrate (11) used to form a solar cell device during a sequence of printing steps, comprising:
- detecting in a detection unit a position of at least one printing track selected between a finger (15) and a busbar (16), said printing tracks (15, 16) forming a first pattern printed onto a surface of the substrate (11) in a first printing station (12) and comprising a plurality of first tracks (15) substantially parallel to each other, which are connected to each other by second tracks (16),
- determining at least one reference point (22) in at least a portion of said printing track (15, 16), wherein the at least one reference point (22) is determined in at least a point of intersection between one of said first tracks (15) and one of said second tracks (16),
- comparing in the detection unit the actual position of said at least one reference point (22) with an expected or previously detected position of said at least one reference point (22);
- determining an offset between the actual position and the expected or previously detected position of said at least one reference point (22);
- adjusting the reciprocal position between the printing head of a second printing station (13) and the substrate (11) for to account for the determined offset; and
- printing a second pattern onto the first pattern.

2. Method as in claim 1, wherein said detecting is carried out with a specific identification member (17) of the detection unit, and wherein said comparing is carried out with a specific comparison member (19) of the detection unit.

3. Method as in claim 1, wherein both said detecting and said comparing are carried out by the same detection unit.

4. Method as in claim 1 wherein, according to the result of the comparison, a correction is commanded of the position of said substrate (11) in order to adjust its position with respect to the position of the printing head of the second printing station (13).

5. Method as in claim 1, wherein, according to the result of the comparison correction is commanded of the position of the printing head of the second printing station (13) in order to adjust its position with respect to the position of the substrate (11).

6. Method as in any claim hereinbefore, in which the substrate is a wafer (11) for the production of photovoltaic cells.

7. Method as in any claim hereinbefore, wherein in said identification step at least three reference points (22) are detected.

8. An apparatus for detecting the alignment of a substrate (11) used to form a solar cell device during a sequence of printing steps, the apparatus being suitable to carry out the method of claim 1, comprising:
- at least one printing station (12, 13) that is configured to deposit the at least one printing track (15, 16) on said substrate (11), wherein said at least one printing track (15, 16) is selected between a finger (15) and a busbar (16),
- the detection unit that is configured to detect the position of the substrate (11) using the at least one reference point (22) formed by at least the portion of the printing track, and
- a control unit that is adapted to adjust the position of a printed pattern formed on the substrate in the at least one printing station based on the detected position of the at least one reference point (22) on said substrate.

9. Apparatus as in claim 8, wherein the detection unit comprises an identification member (17) able to detect the position on the plane of the at least one reference point (22), and a comparison member (19) able to compare the actual position with an expected or previously detected position of the reference point (22) on said substrate.

10. Apparatus as in claim 8, wherein the detection unit comprises a single identification member able both to detect the position on the plane of the at least one reference point (22), and also to compare the actual position with the expected or previously detected position of the reference point (22) on said substrate.

11. Apparatus as in claim 9, wherein the identification member comprises a video camera (21) positioned substantially perpendicular above the substrate (11) and configured to detect the at least one reference point (22).

12. Apparatus as in claim 11, wherein the comparison, member comprises a video camera (21) configured to compare the image detected by the video camera (21) of the identification member (17) with the image actually detected of the substrate (11).

13. Apparatus as in any claim from 8 to 12, wherein it comprises at least a command and control unit (20) electronically connected both to the identification member (17) and also to the comparison member (19) and configured, or selectively able to be configured, to manage the interchange of data between the identification member (17) and the comparison member (19), and also to interpret the comparison signal generated by the comparison member (19).

## Patentansprüche

1. Verfahren zum Detektieren einer Ausrichtung eines Substrats (11), das verwendet wird, um während einer Abfolge von Druckschriften eine Solarzellenvorrichtung auszubilden, umfassend:
- Detektieren einer Position von wenigstens einer Druckspur, die zwischen einem Finger (15) und einer Sammelschiene (16) ausgewählt ist, in einer Detektionseinheit, wobei die Druckspuren (15, 16) ein erstes Muster bilden, das in einer ersten Druckstation (12) auf eine Oberfläche des Substrats (11) gedruckt wird, und das eine Vielzahl von im Wesentlichen zueinander parallelen ersten Spuren (15) umfasst, die durch zweite Spuren (16) miteinander verbunden sind,
- Bestimmen wenigstens eines Referenzpunkts (22) in wenigsten einem Teil der Druckspur (15, 16), wobei der wenigstens eine Referenzpunkt (22) in wenigstens einem Überscheidungspunkt zwischen einer der ersten Spuren (15) und einer der zweiten Spuren (16) bestimmt wird,
- Vergleichen der tatsächlichen Position des wenigstens einen Referenzpunkts (22) mit einer erwarteten oder zuvor detektierten Position des wenigstens einen Referenzpunkts (22) in der Detektionseinheit,
- Bestimmen eines Versatzes zwischen der tatsächlichen Position und der erwarteten oder zuvor detektierten Position des wenigstens einen Referenzpunkts (22),
- Einstellen der gegenseitigen Position zwischen dem Druckkopf einer zweiten Druckstation (13) und dem Substrat (11), um dem bestimmten Versatz Rechnung zu tragen, und
- Drucken eines zweiten Musters auf das erste Muster.

2. Das Verfahren nach Anspruch 1, wobei das Detektieren mit einem spezifischen Identifikationselement (17) der Detektionseinheit ausgeführt wird, und wobei das Vergleichen mit einem spezifischen Vergleichselement (19) der Detektionseinheit ausgeführt wird.

3. Das Verfahren nach Anspruch 1, wobei sowohl das Detektieren als auch das Vergleichen durch dieselbe Detektionseinheit ausgeführt werden.

4. Das Verfahren nach Anspruch 1, wobei gemäß dem Ergebnis des Vergleichs eine Korrektur der Position des Substrats (11) angewiesen wird, um seine Position bezüglich der Position des Druckkopfes der zweiten Druckstation (13) einzustellen.

5. Das Verfahren nach Anspruch 1, wobei gemäß dem Ergebnis des Vergleichs eine Korrektur der Position des Druckkopfes der zweiten Druckstation (13) angewiesen wird, um seine Position bezüglich der Position des Substrats (11) einzustellen.

6. Das Verfahren nach einem der vorstehenden Ansprüche, wobei das Substrat ein Wafer (11) für die Herstellung von Photovoltaikzellen ist.

7. Das Verfahren nach einem der vorstehenden Ansprüche, wobei im Identifikationsschritt wenigstens drei Referenzpunkte (22) detektiert werden.

8. Vorrichtung zum Detektieren einer Ausrichtung eines Substrats (11), das verwendet wird, um während einer Abfolge von Druckschritten eine Solarzellenvorrichtung auszubilden, wobei die Vorrichtung geeignet ist, um das Verfahren gemäß dem Anspruch 1 auszuführen, umfassend:
- wenigstens eine Druckstation (12, 13), die eingerichtet ist, um die wenigstens eine Druckspur (15, 16) auf dem Substrat (11) aufzubringen, wobei die wenigstens eine Druckspur (15, 16) zwischen einem Finger (15) und einer Sammelschiene (16) ausgewählt ist,
- die Detektionseinheit, die eingerichtet ist, um die Position des Substrats (11) unter Verwendung des wenigstens einen Referenzpunkts (22), der durch wenigstens den Teil der Druckspur gebildet ist, zu detektieren, und
- eine Steuereinheit, die angepasst ist, um die Position eines gedruckten Musters, das in der wenigstens einen Druckstation auf dem Substrat ausgebildet wird, basierend auf der detektierten Position des wenigstens einen Referenzpunkts auf dem Substrat einzustellen.

9. Die Vorrichtung nach Anspruch 8, wobei die Detektionseinheit ein Identifikationselement (17) umfasst, das befähigt ist, um die Position auf der Ebene des wenigstens einen Referenzpunkts (22) zu detektieren, und ein Vergleichselement (19), das befähigt ist, um die tatsächliche Position mit einer erwarteten oder zuvor detektierten Position des Referenzpunkts (22) auf dem Substrat zu vergleichen.

10. Die Vorrichtung nach Anspruch 8, wobei die Detektionseinheit ein einzelnes Identifikationselement umfasst, das befähigt ist, um sowohl die Position auf der Ebene des wenigstens einen Referenzpunkts (22) zu detektieren, als auch um die tatsächliche Position mit einer erwarteten oder zuvor detektierten Position des Referenzpunkts (22) auf dem Substrat zu vergleichen.

11. Die Vorrichtung nach Anspruch 9, wobei das Identifikationselement eine Videokamera (21) umfasst, die im Wesentlichen senkrecht über dem Substrat (11) angeordnet ist und eingerichtet ist, um den wenigstens einen Referenzpunkt (22) zu detektieren.

12. Die Vorrichtung nach Anspruch 11, wobei das Vergleichselement eine Videokamera (21) umfasst, die eingerichtet ist, um das von der Videokamera (21) des Identifikationselements (17) detektierte Bild mit dem gegenwärtig detektierten Bild des Substrats (11) zu vergleichen.

13. Die Vorrichtung nach einem der Ansprüche 8 bis 12, umfassend wenigstens eine Befehls- und Steuereinheit (20), die elektronisch sowohl mit dem Identifikationselement (17) als auch mit dem Vergleichselement (19) verbunden ist, und die eingerichtet oder selektiv einrichtbar ist, um den Austausch von Daten zwischen dem Identifikationselement (17) und dem Vergleichselement (19) zu verwalten, und auch um das durch das Vergleichselement (19) erzeugte Vergleichssignal zu interpretieren.

## Revendications

1. Procédé de détection de l'alignement d'un substrat (11) utilisé pour former un dispositif à cellules solaires pendant une séquence d'étapes d'impression, comprenant :
- la détection, dans une unité de détection, d'une position d'au moins une piste d'impression sélectionnée entre un doigt (15) et une barre bus (16), lesdites pistes d'impression (15, 16) formant un premier motif imprimé sur une surface du substrat (11) dans une première station d'impression (12) et comprenant une pluralité de premières pistes (15) sensiblement parallèles les unes aux autres, lesquelles sont connectées les unes aux autres par des deuxièmes pistes (16),
- la détermination d'au moins un point de référence (22) dans au moins une partie de ladite piste d'impression (15, 16), sachant que l'au moins un point de référence (22) est déterminé dans au moins un point d'intersection entre une desdites premières pistes (15) et une desdites deuxièmes pistes (16),
- la comparaison, dans l'unité de détection, de la position effective dudit au moins un point de référence (22) avec une position attendue ou détectée préalablement dudit au moins un point de référence (22) ;
- la détermination d'un décalage entre la position effective et la position attendue ou détectée préalablement dudit au moins un point de référence (22) ;
- le réglage de la position réciproque entre la tête d'impression d'une deuxième station d'impression (13) et le substrat (11) pour tenir compte du décalage déterminé ; et
- l'impression d'un deuxième motif sur le premier motif.

2. Procédé selon la revendication 1, dans lequel ladite détection est effectuée avec un élément d'identification spécifique (17) de l'unité de détection, et dans lequel ladite comparaison est effectuée avec un élément de comparaison spécifique (19) de l'unité de détection.

3. Procédé selon la revendication 1, dans lequel à la fois ladite détection et ladite comparaison sont effectuées par la même unité de détection.

4. Procédé selon la revendication 1, dans lequel, selon le résultat de la comparaison, une correction est ordonnée pour la position dudit substrat (11) afin de régler sa position par rapport à la position de la tête d'impression de la deuxième station d'impression (13).

5. Procédé selon la revendication 1, dans lequel, selon le résultat de la comparaison, une correction est ordonnée pour la position de la tête d'impression de la deuxième station d'impression (13) afin de régler sa position par rapport à la position du substrat (11).

6. Procédé selon l'une quelconque des revendications précédentes, dans lequel le substrat est une plaquette (11) destinée à la production de cellules photovoltaïques.

7. Procédé selon l'une quelconque des revendications précédentes, dans lequel, à ladite étape d'identification, au moins trois points de référence (22) sont détectés.

8. Appareillage destiné à détecter l'alignement d'un substrat (11) utilisé pour former un dispositif à cellules solaires pendant une séquence d'étapes d'impression, l'appareillage étant apte à effectuer le procédé de la revendication 1, comprenant :
- au moins une station d'impression (12, 13) qui est configurée pour déposer l'au moins une piste d'impression (15, 16) sur ledit substrat (11), sachant que ladite au moins une piste d'impression (15, 16) est sélectionnée entre un doigt (15) et une barre bus (16),
- l'unité de détection qui est configurée pour détecter la position du substrat (11) au moyen de l'au moins un point de référence (22) formé par l'au moins une partie de la piste d'impression, et
- une unité de commande qui est apte à régler la position d'un motif imprimé formé sur le substrat dans l'au moins une station d'impression en fonction de la position détectée de l'au moins un point de référence (22) sur ledit substrat.

9. Appareillage selon la revendication 8, dans lequel l'unité de détection comprend un élément d'identification (17) apte à détecter la position sur le plan de l'au moins un point de référence (22), et un élément de comparaison (19) apte à comparer la position effective avec une position attendue ou détectée préalablement du point de référence (22) sur ledit substrat.

10. Appareillage selon la revendication 8, dans lequel l'unité de détection comprend un élément d'identification unique apte à la fois à détecter la position sur le plan de l'au moins un point de référence (22) ainsi qu'à comparer la position effective avec la position attendue ou détectée préalablement du point de référence (22) sur ledit substrat.

11. Appareillage selon la revendication 9, dans lequel l'élément d'identification comprend une caméra vidéo (21) positionnée de manière sensiblement perpendiculaire au-dessus du substrat (11) et configurée pour détecter l'au moins un point de référence (22).

12. Appareillage selon la revendication 11, dans lequel l'élément de comparaison comprend une caméra vidéo (21) configurée pour comparer l'image détectée par la caméra vidéo (21) de l'élément d'identification (17) avec l'image effectivement détectée du substrat (11).

13. Appareillage selon l'une quelconque des revendications 8 à 12, sachant qu'il comprend au moins une unité d'ordre et de commande (20) connectée électroniquement à la fois à l'élément d'identification (17) ainsi qu'à l'élément de comparaison (19) et configuré, ou sélectivement apte à être configuré, pour gérer l'échange mutuel de données entre l'élément d'identification (17) et l'élément de comparaison (19), ainsi qu'à interpréter le signal de comparaison généré par l'élément de comparaison (19).
